# EUROPÄISCHE PATENTSCHRIFT

(11) **EP 1 110 234 B1**
(45) Veröffentlichungstag und Bekanntmachung des Hinweises auf die Patenterteilung: **06.12.2006**
(21) Anmeldenummer: 99941651.4
(22) Anmeldetag: 20.08.1999
(51) Int. Cl.: H01J 37/32

(54) **VORRICHTUNG UND VERFAHREN ZUR BESCHICHTUNG VON SUBSTRATEN IM VAKUUM**
DEVICE AND METHOD FOR COATING SUBSTRATES IN A VACUUM
DISPOSITIF ET PROCEDE POUR APPLIQUER UN REVETEMENT SUR DES SUBSTRATS SOUS VIDE

(30) Priorität: 26.08.1998 DE 19838827; 31.10.1998 DE 19850218
(43) Veröffentlichungstag der Anmeldung: 27.06.2001
(73) Patentinhaber: Fraunhofer-Gesellschaft zur Förderung der angewandten Forschung e.V., 80686 München (DE)
(72) Erfinder: MEYER, Carl-Friedrich, D-01474 Pappritz (DE); SCHEIBE, Hans-Joachim, D-01309 Dresden (DE)
(74) Vertreter: Pfenning, Meinig & Partner GbR
(86) Internationale Anmeldenummer: PCT/EP1999/006128
(87) Internationale Veröffentlichungsnummer: WO 2000/013201

(56) Entgegenhaltungen:
- DD-A- 279 695
- DE-A- 3 901 401
- PATENT ABSTRACTS OF JAPAN vol. 018, no. 068 (C-1161), 4. Februar 1994 (1994-02-04) & JP 05 279844 A (MATSUSHITA ELECTRIC IND CO LTD), 26. Oktober 1993 (1993-10-26)
- COLL B F ET AL: "Design of vacuum arc-based sources" FIRST AUSTRALIA-USA WORKSHOP ON CRITICAL ISSUES IN HIGH PERFORMANCE WEAR RESISTANT FILMS, WOLLONGONG, NSW, AUSTRALIA, 1-3 FEB. 1995, Bd. 81, Nr. 1, Seiten 42-51, XP002124098 Surface and Coatings Technology, May 1996, Elsevier, Switzerland ISSN: 0257-8972 in der Anmeldung erwähnt

## Beschreibung

Die Erfindung betrifft eine Vorrichtung und ein Verfahren zur Beschichtung von Substraten im Vakuum, wobei von einem Target ein Plasma erzeugt und ionisierte Teilchen des Plasmas auf dem Substrat als Schicht abgeschieden werden sollen, wie dies bei den verschiedensten bekannten PVD-Verfahren seit längerer Zeit erfolgreich angewendet wird.

Insbesondere ist die Erfindung in Ergänzung des sogenannten Laeer-Arc-Verfahrens, bei dem eine Bogenentladung im Vakuum mittels eines gepulst betriebenen Laserstrahls gezündet und mit dem über die Bogenentladung erhaltenen Plasma der ionisierte Teilchenstrom zu einem Substrat geführt und auf diesem als Schicht die ionisierten Teilchen abgeschieden werden können, anwendbar. Die Erfindung kann aber auch bei einem an sich bekannten Verfahren, bei dem eine Bogenentladung im Vakuum zur Erzeugung des Plasmas benutzt wird, ohne daß die Bogenentladung mit einem Laserstrahl initiiert wird, angewendet werden. Dabei kann die Bogenentladung auf bekannte Art und Weise, entweder allein durch eine ausreichend hohe Spannung zwischen einer Anode und einem als Kathode geschalteten Target gezündet werden und zum anderen besteht die Möglichkeit, die Zündung mittels elektrisch leitender Zündelemente infolge Kurzschluß zu initiieren.

Eine weitere Möglichkeit, bei der die erfindungegemäße Lösung sinnvoll angewendet werden kann, ist die Erzeugung eines Plasmas auf einem Target durch Eestrahlung der Targetoberfläche mit einem Laserstrahl entsprechend ausreichender Intensität.

Diese drei möglichen Verfahren sind beispielhaft in DE 39 01 401 C1 und DD 279 695 B5 für das Laser-Arc-Verfahren, DD 280 338 B5 für die reine Bogenentladungsverdampfung und in US 4,987,007 für die Laserstrahl-Plasmaerzeugung beschrieben.

Diese bekannten Verfahren, weisen jedoch den Nachteil auf, daß ihr Plasma relativ reich an Tröpfchen und Partikeln ist, die zu lokalen Abweichungen in den Schichteigenschaften führen und die entsprechend beschichteten Substrate dann für viele Anwendungsfälle nicht geeignet sind.

Um diesem Nachteil entgegenzutreten wurden aber Möglichkeiten vorgeschlagen, um eine sogenannte "Filterung" des Plasmas zur Speicherung von Partikeln durchzuführen. Mehrere Möglichkeiten hierfür sind von B.F. Coll und D.M. Sanders in "Design of Vacuum Arc-Basis Sources"; Surface and Coatings Technology", No. 81 (1996) 42 - 51 beschrieben. Dabei wird bei diesen bekannten Lösungen davon ausgegangen, daß unter Verwendung magnetischer Felder die ionisierten leichten Bestandteile eines Plasmas abgelenkt werden können und die wesentlich größeren, wegen ihres ungünstigen Ladungs-/Masseverhältnisses, schwerer ablenkbaren Partikel voneinander getrennt werden können.

Diese Filteranordnungen haben jedoch einige erhebliche Nachteile:
Der Aufbau dieser Systeme ist sehr komplex und entsprechend teuer. Der Durchmesser der magnetischen Filter und damit der Durchmesser der Beschichtungsfläche ist auf Grund der benötigten kräftigen magnetischen Felder und der dazu benötigten elektrischen Leistungen auf ca. 150 mm begrenzt. Die Beschichtungsrate der Verfahren wird auf ca. 15 - 20 % im Vergleich zu der ohne Verwendung des Filters verringert.

Des Weiteren ist in JP 05-279844 A Patent Abstracts of Japan, vol. 018, no. 068 (C-1161) eine Vorrichtung zur Beschichtung von Substraten im Vakuum beschrieben. Dabei wird mittels eines Laserstrahls, der auf ein Target gerichtet wird, ein Plasma erzeugt. Die elektrisch geladenen und neutralen Plasmateilchen gelangen vom Target zum Substrat, wobei mit zwei sich parallel gegenüberliegend angeordneten und orthogonal zur Targetoberfläche ausgerichteten Elektroden, durch Anlegen einer Spannung in Höhe von 1000 V negativ geladene Partikel von den Elektroden absorbiert werden sollen.

Es ist daher Aufgabe der Erfindung, den Anteil an Tröpfchen und Partikeln, in einer auf einem Substrat mit einem PVD-Verfahren aufgebrachten Schicht zu verringern, wobei gleichzeitig eine relativ großflächige Beschichtung ermöglicht sein soll.

Erfindungsgemäß wird diese Aufgabe mit den Merkmalen des Anspruchs 1 für erfindungsgemäße Vorrichtungen und den Merkmalen des Anspruchs 13 für ein entsprechendes Verfahren zur Beschichtung von Substraten im Vakuum gelöst. Vorteilhafte Ausgestaltungsformen und Weiterbildungen der Erfindung, ergeben sich mit den in den untergeordneten Ansprüchen enthaltenen Merkmalen.

Erfindungsgemäß wird dabei so verfahren, dass eine zusätzliche gegenüber dem Plasma auf einem elektrisch positiven Potential liegende Absorberelektrode verwendet wird, um die ein elektrisches Feld erzeugt wird. Durch dieses elektrische Feld werden ionisierte Teilchen und Elektronen eines Plasmas hindurch geführt und dadurch erreicht, dass elektrisch negative Teilchen von der Absorberelektrode absorbiert und positive Teilchen, bevorzugt mit kleinem Masse-Ladungsverhältnis des Plasmas zum Substrat gelangen. Neutrale Teilchen und Teilchen mit großem Masse-Ladungsverhältnis werden in ihrer Bezugsgröße nur unwesentlich beeinflusst und können so separiert werden.

Eine solche Absorberelektrode ist gegenüber den bekannten verwendeten magnetischen Filtersystemen wesentlich einfacher und kostengünstiger herstell- und betreibbar.

Eine besonders vorteilhafte Ausgestaltungsform der Erfindung besteht darin, diese in einer Vorrichtung zu verwenden, bei der eine gepulste Vakuum-Bogenentladung mit einem gepulsten Laserstrahl, der auf die Oberfläche eines als Kathode geschalteten Targets gerichtet ist, verwendet wird. Solche Vorrichtungen mit den entsprechenden Verfahren sind, z.B. in DE 39 01 401 C2 und in einer verbesserten Form in DD 279 695 B5 beschrieben. Die Vakuumbogenentladung zur Erzeugung eines Plasmas wird zwischen dem Target und einer Anode gezündet und die ionisierten Teilchen des Plasmas werden dann nachfolgend auf einem Substrat als Schicht abgeschieden. Hierfür können die verschiedensten Formen für die Ausbildung der Anode und des verwendeten Targets angewendet werden, wobei die verschiedensten Targetmaterialien einsetzbar sind. Bei Verfahren, wie dies z.B. in DD 279 695 B5 beschrieben ist, treten die aus dem Stand der Technik bekannten Nachteile der Abscheidung der relativ großen Partikel in der Schicht auf. Um dem entgegenzuwirken, wird erfindungsgemäß eine zusätzliche Absorberelektrode eingesetzt, die gegenüber der gegebenenfalls ohnehin vorhandenen Anode auf einem elektrisch positiverem Potential gehalten wird. Mit dieser Anordnung gelingt es, eine Trennung der unterschiedlich geladenen Teilchen des ionisierten Teilchenstromes aus dem Plasma durchzuführen, wobei die elektrisch negativen Teilchen zumindest zum größten Teil von der Absorberelektrode absorbiert und in der erfindungsgemäß gewünschten Form lediglich die elektrisch positiven Teilchen des Teilchenstromes durch ein um eine Absorberelektrode erzeugtes elektrisches Feld auf das Substrat gelangen. Dabei ist es besonders günstig, den Abstand zwischen der Anode und der Absorberelektrode relativ klein, auf etwa einige wenige mm zu begrenzen.

Die Erfindung kann aber auch in einer Vorrichtung bzw. in einem Verfahren angewendet werden, bei dem das Plasma ausschließlich mittels einer Bogenentladung im Vakuum erzeugt wird, wie dies neben anderen in DD 280 338 B5 beschrieben ist. Dabei wird die Bogenentladung entweder allein durch eine Spannungserhöhung oder in Verbindung mit der Erzeugung eines Kurzschlusses initiiert. Auch in diesem Fall wird wieder ein als Kathode geschaltetes Target und eine Anode in einer Vakuumkammer verwendet, zwischen denen ein Lichtbogen, bevorzugt gepulst gezündet und ein Plasma aus dem Targetmaterial erzeugt wird. Wird aber nach Zündung mit einer kontinuierlichen Bogenentladung gearbeitet, sollte der Bogen mit Hilfe steuerbarer Magnetfelder entlang der Oberfläche des Targets geführt werden.

Auch in diesem Fall wird wiederum die Absorberelektrode in unmittelbarer Nähe des Targets und/oder der Anode angeordnet. Um die Absorberelektrode wird ein elektrisches Feld erzeugt, wobei die Absorberelektrode wiederum gegenüber dem Plasma auf einem elektrischen positiven Potential gehalten ist, so daß die positiven Teilchen des Teilchenstromes aus dem Plasma in Richtung auf das Substrat bewegt werden und dort die Schicht gebildet wird, ohne daß die größeren bzw. massereicheren geladenen Teilchen des Teilchenstromes zum Substrat gelangen, da sie auf die Absorberelektrode treffen und absorbiert werden können.

Die erfindungsgemäß zu verwendende Absorberelektrode kann aber auch in einer Vorrichtung bzw. bei einem Verfahren verwendet werden, bei dem das Plasma von einem Target mit einem Laserstrahl, der auf dieses gerichtet ist, erzeugt wird. Eine solche Vorgehensweise ist z. B. in US 4,987,007 beschrieben. In diesem Fall kann auch ein Plasma aus einem Targetmaterial, das nicht leitend ist, erzeugt werden. Auch hier wird wieder die Absorberelektrode in unmittelbarer Nähe des Fußpunktes des Plasmas, d. h. der Fokuspunkt des Laserstrahls auf dem Target angeordnet. Auch in diesem Fall wird die Trennung der unterschiedlich geladenen Teilchen des ionisierten Teilchenstromes in der bereits bei den anderen Möglichkeiten beschriebenen Form durchgeführt, so dass nahezu ausschließlich positiv geladene Teilchen des Teilchenstromes auf das Substrat gelangen und dort die Schicht ausbilden.

Erfindungsgemäß wird die Absorberelektrode und/oder das Substrat so angeordnet bzw. ausgebildet, dass keine Teilchen und Ionen aus dem Plasma direkt auf das Substrat gelangen können. Hierfür kann auch zusätzlich eine abschirmende Blende eingesetzt werden, die zwischen Target und Substrat entsprechend angeordnet werden kann.

Die Absorberelektrode wird so angeordnet, ausgerichtet und dimensioniert dass der Teilchenstrom des Plasmas nicht auf direktem Weg zum Substrat gelangen kann. Im einfachsten Fall kann es sich um eine entsprechend geneigt planare Ebene handeln. Es kann aber auch eine konvex gekrümmte Fläche aufgespannt sein.

An der Absorberelektrode muss nicht zwingend eine geschlossene Fläche vorhanden sein, sondern es können auch lückenbehaftete Elemente, wie z. B. Gitter, Loch- oder Schlitzbleche bzw. andere Strukturelemente eingesetzt werden.

Die erfindungsgemäße Wirkung der verwendeten Absorberelektrode beruht auf dem hohen Ionisierungsgrad des Plasmas, der mit den bereits genannten Verfahren erreicht werden kann, ohne dass die Ionen eine hohe kinetische Energie aufweisen müssen. Die Energie der Ionen liegt hierbei zwischen 30 bis 100 eV. Bekanntermaßen beträgt der Ionisierungsgrad eines Plasmas bei einer Vakuumbogenentladung etwa 80 bis 90 %.

Die Absorberelektrode hat allein die Funktion der Trennung der unterschiedlich geladenen Teilchen des Teilchenstromes aus dem Plasma und führt nicht dazu, das eine Beschleunigung der ionisierten Teilchen erreicht wird.

Durch die Anordnung der Absorberelektrode in unmittelbarer Nähe der Anode bzw. des Targets, wird ein sehr großer Teil der Elektronen und negativ geladenen Ionen absorbiert und gleichzeitig verhindert, dass sich durch Rekombinationsprozesse der Ionisierungsgrad der Ionen wesentlich vor dem Verlassen der mit der Absorberelektrode in Verbindung mit dem elektrischen Feld ausgebildeten Umlenkanordnung ändert.

Die Beschichtungsrate kann positiv beeinflusst werden, in dem die Absorberelektrode, das Substrat und die anderen gegebenenfalls für die Erzeugung des Plasmas erforderlichen Komponenten in günstiger Weise ausgebildet und/oder angeordnet werden. Besonders geeignete Ausführungsformen werden nachfolgend noch näher beschrieben werden.

Bei entsprechender Form der Absorberelektrode kann erreicht werden, daß bei Eintritt des Plasmas in das um die Absorberelektrode erzeugte elektrische Feld, der elektrische Feldvektor orthogonal zur Bewegungsrichtung des Ionenstromes ausgerichtet ist und so die kinetische Energie der Ionen nur geringfügig beeinflußt wird. Aus diesem Grund können nahezu ausschließlich die Ionen optimal als positiv geladene Raumladung zum Substrat, infolge der Wirkung des elektrischen Feldes, umgelenkt werden. Das Substrat erwärmt sich nur in sehr geringem Maße, so daß der eigentliche Beschichtungsvorgang beinahe bei Raumtemperatur durchgeführt wird, so daß auch entsprechende thermisch sensible Substrate ohne weiteres beschichtet werden können.

Durch eine am Substrat angelegte negative Spannung, kann die Energie der Ionen und dadurch auch die Eigenschaften der ausgebildeten Schicht gezielt beeinflußt werden.

Günstig kann es außerdem sein, ein z.B. gitterförmiges Element aus einem elektrisch leitenden Material zwischen dem Fußpunkt des Plasmas und der Absorberelektrode anzuordnen, durch das das Plasma geführt ist. Ein solches gitterförmiges Element kann auf das elektrische Potential der Anode gelegt werden. Außerdem kann es vorteilhaft sein, daß gitterförmige Element in Richtung der Bewegungsrichtung des Plasmas gewölbt auszubilden. Das gitterförmige Element kann mit der Anode und gegebenenfalls einer verwendeten Blende verbunden und demzufolge auch daran befestigt sein.

Die Erfindung kann vorteilhaft auch zur Ausbildung von reaktiv beeinflußten Schichten eingesetzt werden. Hierzu können Gase zugeführt werden. Diese Gase werden in der Nähe der Absorberelektrode ionisiert und chemisch aktiviert, so daß mit z.B. Stickstoff, Sauerstoff, H₂, Kohlenwasserstoffe, bei geringem Massenstrom und demzufolge sehr kleinen Gasdrücken unterhalb 10⁻¹ Pa, z.B. oxidische, carbidische oder nitridische Schichten oder einer Kombination, wie z.B. Carbonitride erzeugt werden können.

Nachfolgend soll die Erfindung beispielhaft beschrieben werden.

Dabei zeigen:
- Figur 1: ein Beispiel einer erfindungsgemäßen Vorrichtung, bei der ein Plasma mit einem Laser-Arc-Verfahren erzeugt und eine gekrümmte Absorberelektrode eingesetzt wird;
- Figur 1a: das Beispiel nach Figur 1 in perspektivischer Darstellung;
- Figur 2: ein Beispiel einer erfindungsgemäßen Vorrichtung, bei dem ein Plasma mit einem Laser-Arc-Verfahren erzeugt und eine gekrümmte, aus einer Mehrzahl von Streifen gebildete Absorberelektrode verwendet wird;
- Figur 2a: das Beispiel nach Figur 2 in perspektivischer Darstellung;
- Figur 3: ein Beispiel einer erfindungsgemäßen Vorrichtung, bei der ein Plasma mit einem Laserstrahl erzeugt und eine gekrümmte, auseiner Mehrzahl von Einzelstreifen gebildete Absorberelektrode verwendet wird;
- Figur 3a: das Beispiel nach Figur 3 in perspektivischer Darstellung;
- Figur 4: ein Beispiel einer erfindungsgemäßen Vorrichtung mit aus streifenförmigen Elementen gebildeter Absorberelektrode;
- Figur 5: ein Beispiel einer erfindungsgemäßen Vorrichtung mit aus streifenförmigen Elementen gebildeter Absorberelektrode, bei der das Plasma ausschließlich mit einem Laserstrahl erzeugt wird und
- Figur 6: ein weiteres Beispiel einer erfindungsgemäßen Vorrichtung mit einer Absorberelektrode, die Anodenfunktion zur Erzeugung von Plasma mittels Bogenentladung erfüllt.

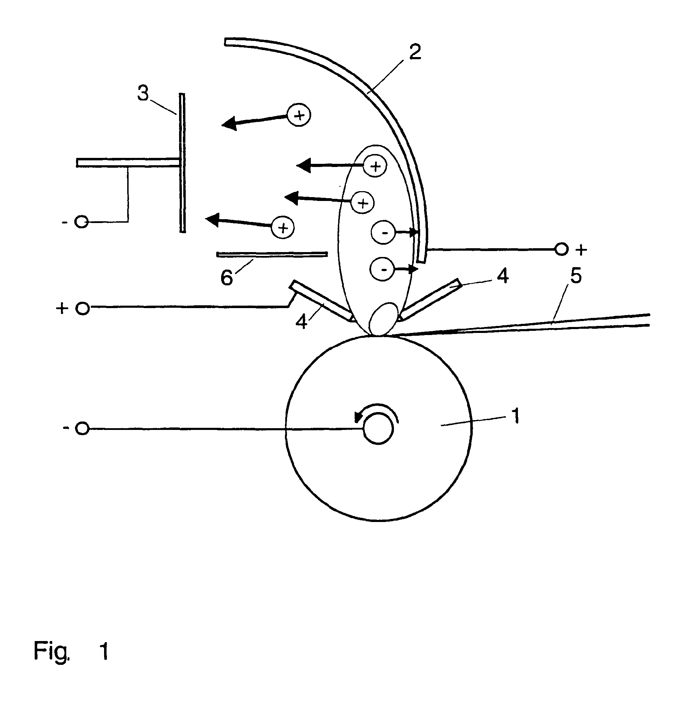

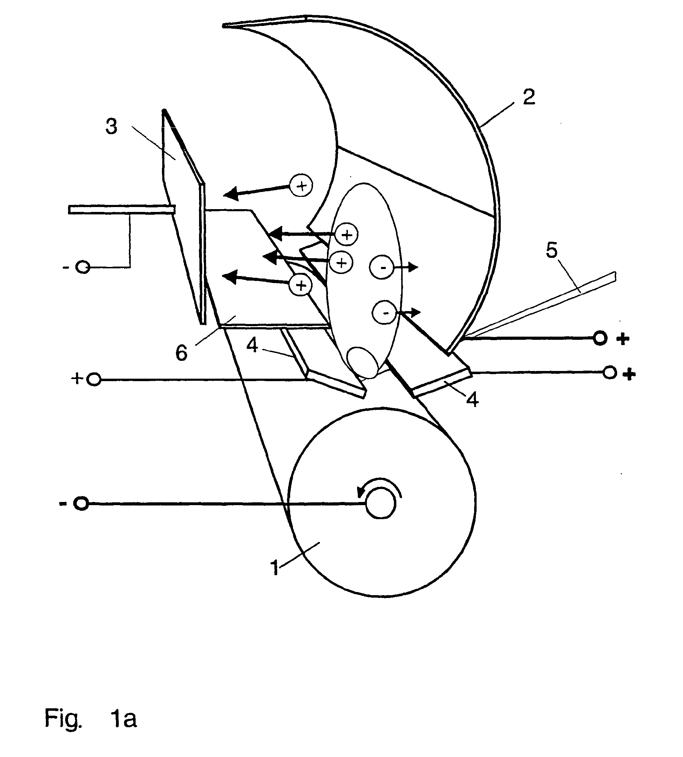

Bei den in den Figuren 1 bis 6 gezeigten Vorrichtungen, wurde sämtlichst auf die Darstellung der Vakuumkammer, in der die in den Figuren dargestellten einzelnen Komponenten aufgenommen sind, verzichtet, da davon ausgegangen werden kann, daß dies für den einschlägigen Fachmann auf der Hand liegt.

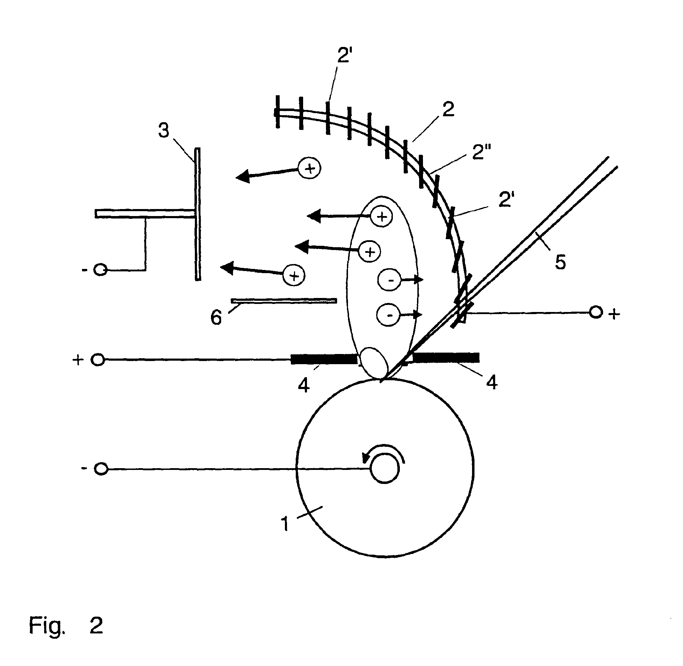

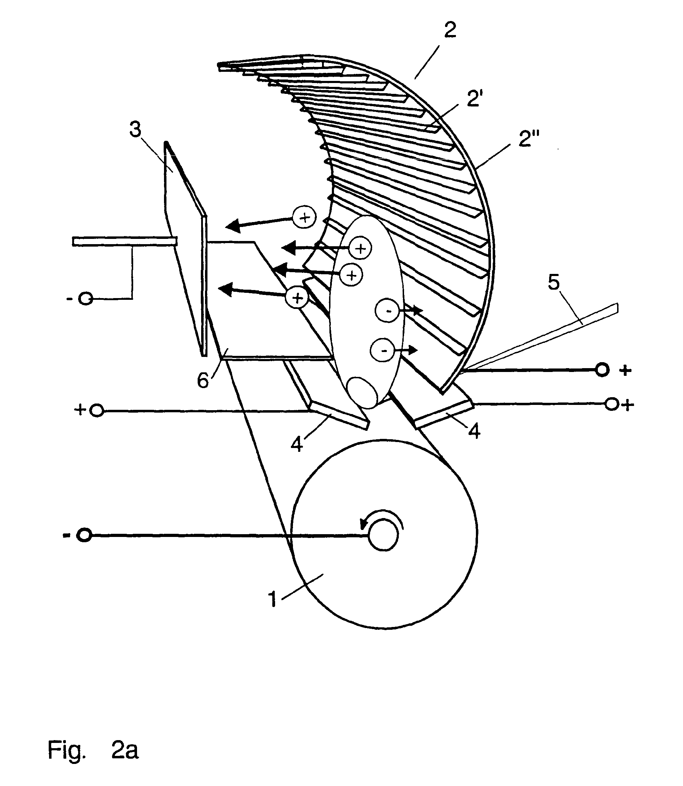

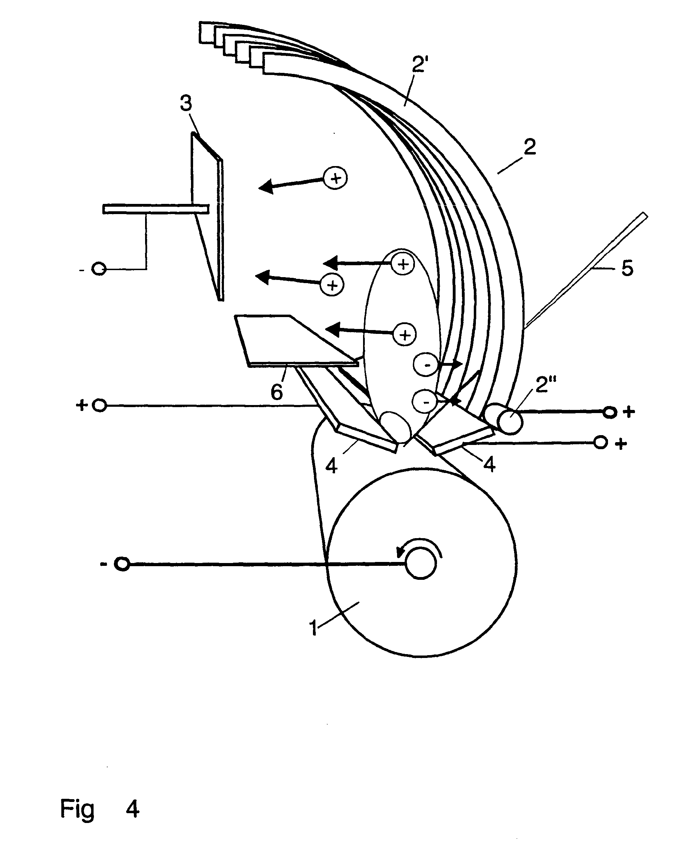

Bei dem in der Figur 1 gezeigten Beispiel einer erfindungsgemäßen Vorrichtung, wird ein walzenförmiges Target 1 verwendet, das um seine Längsachse gleichförmig gedreht wird. Für die Erzeugung eines Plasmas aus einer Bogenentladung wird eine Anode 4 verwendet, die in bevorzugter Form als Anodenschirm mit einem zentralen Spalt, durch den das erzeugte Plasma austreten kann, ausgebildet ist, wie dies mit der in Figur 1 und 1a sowie auch den Figuren 2, 2a und 4 dargestellten Form der Anode 4 angedeutet ist. Zur Zündung der Vakuum-Bogenentladung wird ein Laserstrahl 5 in gepulster Form auf die Manteloberfläche des Targets 1 gerichtet und gleichzeitig die Anodenspannung entsprechend erhöht, so daß eine Bogenentladung zwischen Target 1 und Anode 4 gezündet und im Anschluß an die Verdampfung von Targetmaterial ein Plasma erzeugt werden kann, das durch den Anodenspalt in Richtung auf die hier gekrümmte, der Form eines Teilkreises folgend, ausgebildete Absorberelektrode 2 gelangt.

Die Absorberelektrode 2 ist an eine Gleichspannung angelegt. Diese Spannung an der Absorberelektrode 2 liegt oberhalb der normalen Spannung an der Anode 4 und des Potentials des Plasmas.

Mit der Absorberelektrode 2 kann eine Trennung der verschieden geladenen Teilchen im ionisierten Teilchenstrom aus dem Plasma durchgeführt werden. Hierfür werden die negativ geladenen Ionenteilchen von der Absorberelektrode 2 absorbiert und die positiv geladenen Teilchen aus dem Teilchenstrom können sich in Richtung auf das Substrat 3 bewegen und an dessen Oberfläche die gewünschte nahezu partikel- und tröpfchenfreie Schicht ausbilden. Dabei wirkt sich das zwischen Absorberelektrode 2 und Substrat 3 ausgebildete elektrische Feld lediglich günstig für die gewünschte Ladungstrennung aus und die kinetische Energie der positiv geladenen Teilchen wird nicht zusätzlich erhöht.

Bei diesem Beispiel ist an dem Substrat 3 ein elektrisch negatives Potential angelegt, was für bestimmte Zwecke günstig sein kann. Es ist aber nicht generell erforderlich, das Substrat auf ein elektrisch negatives Potential zu legen, sondern es kann ohne weiteres auch ein Anschluß an die Masse der Vorrichtung ausreichend sein.

Vorteilhaft befindet sich der Spannungsanschluß zur Absorberelektrode 2, wie in Figur 1 deutlich erkennbar, an der dem Target 1 zugewandten Seite der Absorberelektrode 2, möglichst nahe dem Fußpunkt des Plasmas.

Zur Verhinderung, daß sich ionisierte Teilchen unmittelbar, d.h. auf geradem, direktem Wege in Richtung auf das Substrat 3 bewegen, kann eine Blende 6 verwendet werden, die zwischen Target 1 und Substrat 3 angeordnet ist. Sie gibt lediglich einen verengten Spalt zwischen Blende 6 und Absorberelektrode 2 für den Durchtritt des Plasmas frei.

Mit diesem Verfahren bzw. einer solchen Vorrichtung können relativ großformatige Substrate 3 beschichtet werden, wobei entsprechend lange walzenförmige Targets 1 verwendet werden können. In diesem Falle sollten entsprechend lange Absorberelektroden 2 verwendet werden, so daß die gewünschte Wirkung über die gesamte Targetlänge und die gesamte zu beschichtende Fläche des Substrates 3 durch ein entsprechend ausgedehntes elektrisches Feld erreicht werden kann.

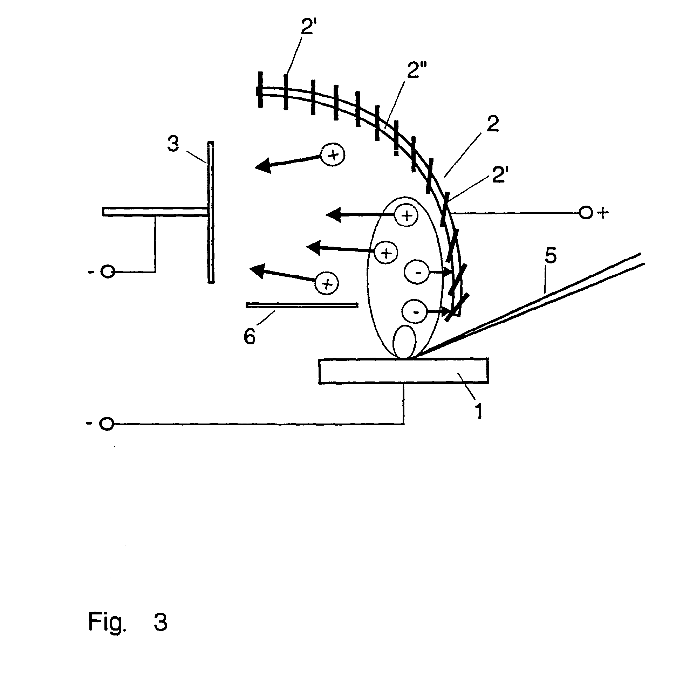

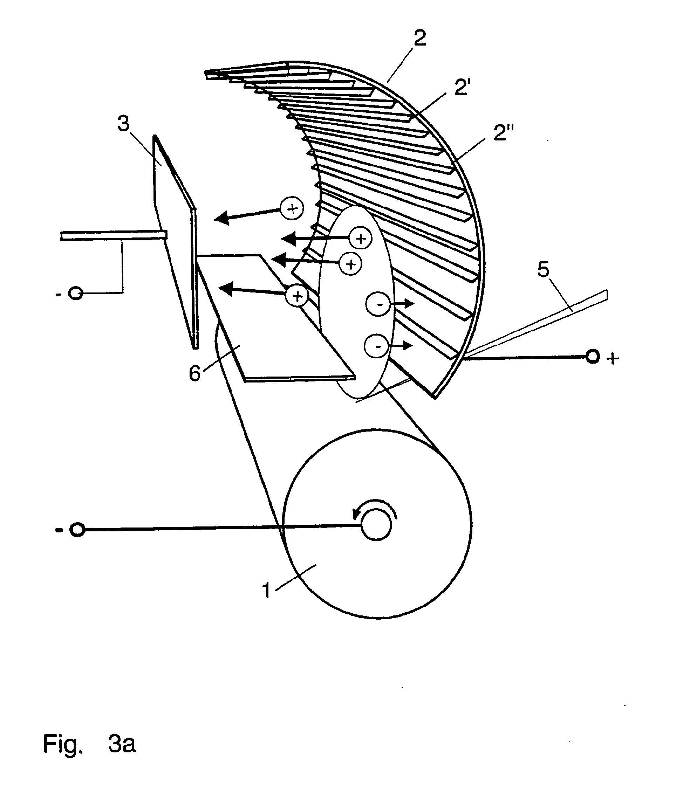

Bei dem in den Figuren 3 und 3a gezeigten Beispiel einer erfindungsgemäßen Vorrichtung werden wieder die gleichen einzelnen Komponenten verwendet, wie dies auch bei dem Beispiel nach Figur 1 der Fall ist. Im Gegensatz hierzu ist lediglich die Absorberelektrode 2 modifiziert ausgebildet. Die Absorberelektrode 2 besteht hier aus einem Streifenträger 2'', an dem einzelne schmale Streifen 2' aus elektrisch leitendem Material in einem Abstand voneinander befestigt sind. Die Streifen 2' sind dabei so ausgerichtet, daß ein reflektiertes ionisiertes Teilchen vom Substrat weg reflektiert wird.

Bei dem in Figuren 3 und 3a gezeigten Beispiel einer erfindungsgemäßen Vorrichtung wird ein herkömmliches Target 1 verwendet, bei dem in diesem Fall ein negatives Potential angelegt ist, wobei hierauf aber auch verzichtet werden kann. Auf das Target 1 wird ein bevorzugt gepulster Laserstrahl 5 gerichtet und das Plasma allein mit dessen Energie aus dem Targetmaterial erzeugt. Das Target 1 kann aus elektrisch leitendem aber auch aus elektrisch nicht leitendem Material bestehen, je nachdem welche Schicht auf dem Substrat 3 ausgebildet werden soll. Im übrigen ist diese Vorrichtung, genau wie das in Verbindung mit der Figur 3 beschriebene Beispiel ausgebildet. Selbstverständlich können auch Ausführungsformen gemäß den anderen beschriebenen Beispielen, insbesondere für die Ausbildung der Absorberelektrode 2 verwendet werden.

Bei einer Vorrichtung, wie sie mit den Beispielen gemäß den Figuren 1, 1a, 2 und 2a beschrieben worden und die in Verbindung mit dem bekannten Laser-Arc-Verfahren betrieben werden kann, können verschiedenste Schichten auf verschiedensten Substraten aufgebracht werden. So können partikelfreies Aluminium, verschiedene Aluminiumverbindungen (durch Zugabe entsprechend reaktiver Gase) und auch diamantähnliche Kohlenstoffschichten aufgebracht werden.

Nachfolgend soll die Beschichtung eines Substrates mit Aluminium als Beispiel beschrieben werden.

Hierzu wird ein walzenförmiges Aluminiumtarget 1 verwendet und die Anode 4 zur Erzeugung der Bogenentladung im Vakuum sowie die Absorberelektrode 2 weisen die gleiche Länge, wie das walzenförmige Aluminiumtarget 1 auf. Bei diesem Beispiel wird eine Absorberelektrode 2, gemäß Figur 1 verwendet, deren Krümmungsradius 60 mm beträgt. Für die Zündung der Vakuum-Bogenentladung wird eine Impulsspitzenspannung von ca. 400 V an die Anode 4 angelegt. Nachdem die Zündung der Vakuum-Bogenentladung zwischen Anode 4 und Target 1 mit Hilfe des Laserstrahls 5 (Leistungsdichte 5*10⁸ W/cm²) erfolgt ist, wird die Anodenspannung innerhalb weniger Mikrosekunden auf die Bogenentladungsspannung von ca. 30 V reduziert. Die Stromstärke der Bogenentladung beträgt ca. 1.000 A, die Impulsfrequenz, mit der die Vakuum-Bogenentladung durchgeführt wird, liegt bei ca. 100 Hz.

Die Spannung an der Absorberelektrode 2 konnte bei mittleren Werten im Bereich zwischen 180 V und 200 V und die mittlere Stromstärke bei 3 A gehalten werden.

Das isoliert in der Vakuumkammer aufgehängte Substrat 3 kann im Gegensatz zu den beispielhaften Darstellungen auf Massepotential gehalten werden. Mit einer solchen Anordnung können Beschichtungsraten realisiert werden, die bei ca. 40 %, einer Vorgehensweise ohne die erfindungsgemäße Lösung, d.h. ohne zusätzliche Absorberelektrode, erreicht werden.

Die Absorberelektrode 2 kann aber auch, wie in Figur 4 gezeigt, ausgebildet werden. Sie wird aus mehreren in einem Abstand zueinander angeordneten ebenen, flächigen Elementen (Streifen 2') gebildet, wobei die einzelnen Elemente parallel zueinander ausgerichtet sind und die einzelnen, die Absorberelektrode 2 bildenden Elemente orthogonal zur Längsrichtung des Targets 1 ausgerichtet sind, so daß durch die Zwischenräume zwischen benachbarten flächigen Elementen im Plasma gegebenenfalls vorhandene größere Tröpfchen abgeführt werden können und demzufolge eine Abscheidung auf dem Substrat 3 vermieden werden kann.

Die ebenen, flächigen Elemente (Streifen 2') einer so ausgebildeten Absorberelektrode 2 können an der dem Plasma zugewandten Seite bevorzugt so geformt sein, wie dies bei den Streifenträgern 2'' in den Figuren 3 und 4 gezeigt ist. Die einzelnen ebenen, flächigen Elemente 2' können mit mindestens in einer Achse angeordneten Abstandshaltern, auch elektrisch leitend, verbunden sein.

Die einzelnen Streifen 2' sind bei diesem Beispiel kammförmig nebeneinander angeordnet und konvex gekrümmt.

Da die Position des Fußpunktes des Plasmas auf der Targetoberfläche wechseln kann, ist es vorteilhaft, die einzelnen Streifen 2' gesondert anzusteuern, d.h. jeder Streifen 2' verfügt über eine gesonderte Stromzuführung, so daß lediglich die Streifen 2' mit einem entsprechend ausreichend hohen elektrischen Strom versorgt werden, die das erzeugte Plasma wirksam beeinflussen können. Die übrigen Streifen 2' können mit kleinerer Spannung beaufschlagt oder sogar spannunglos geschaltet sein. So können z.B. nebeneinanderliegende Streifen 2' auf einer Länge von ca. 100 bis 400 mm mit elektrischem Strom versorgt werden, wobei das Ein- und Ausschalten der einzelnen Streifen 2' unter Berücksichtigung der Position des Fußpunktes des Plasma auf dem Target 1 gesteuert werden sollte. Dies kann beispielsweise unter Berücksichtigung der Strahlrichtung bzw. Auslenkung des Laserstrahles 5 erfolgen.

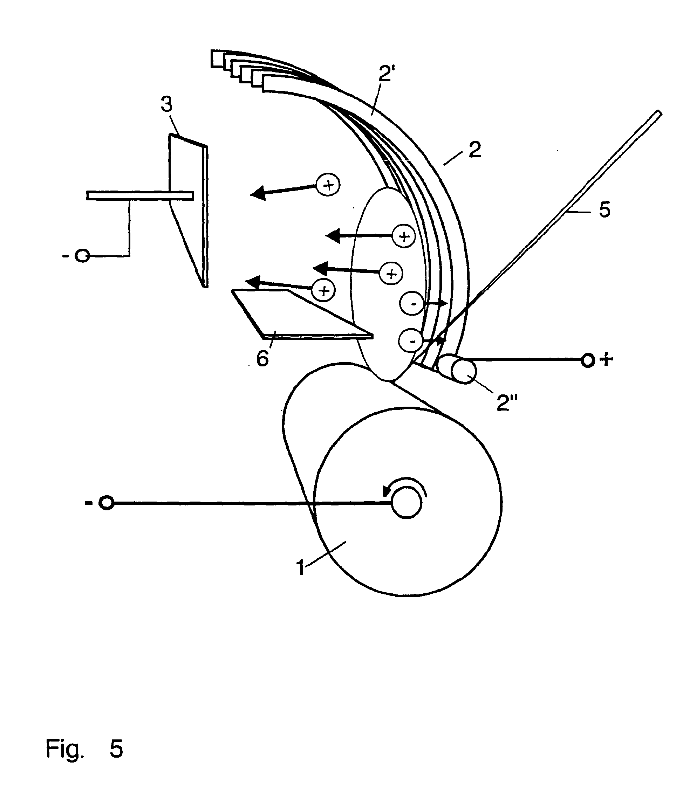

Das in Figur 5 gezeigte Beispiel entspricht im wesentlichen dem vorhergehend beschriebenen. Es wird lediglich auf eine zusätzliche Anode 4 verzichtet und das Plasma ausschließlich mit der Energie eines Laserstrahles 5 erzeugt, der bei gleichzeitiger Drehung des Targets 1 entlang dessen Längsachse ausgelenkt wird. Auch hier kann die Stromzuführung zu den einzelnen Streifen 2' der Absorberelektrode 2 entsprechend gesteuert werden.

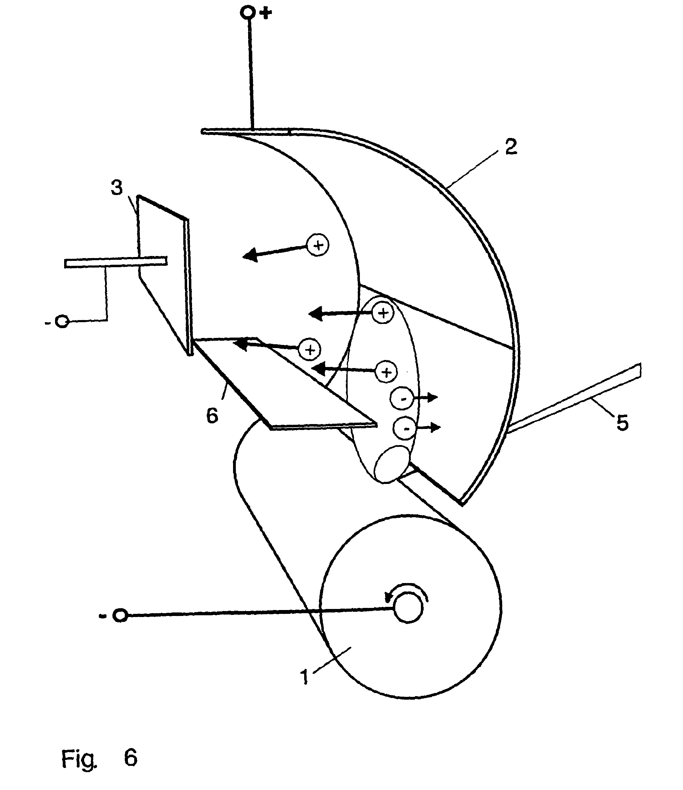

Das in der Figur 6 gezeigte Beispiel verzichtet auf eine zusätzliche Anode 4, deren Funktion von der Absorberelektrode 2 übernommen wird. Die Bogenentladung wird demzufolge von der Absorberelektrode 2, ggf. mit Unterstützung eines gepulsten Laserstrahles 5 initiert.

In diesem Fall ist die Stromzuführung zur Absorberelektrode 2 möglichst weit vom Fußpunkt des Plasmas, demzufolge an bzw. in der Nähe der in Richtung Substrat 3 weisenden Stirnfläche der Absorberelektrode 2 angeordnet. Je größer der Abstand, um so günstiger ist die Wirkung der Absorberelektrode 2.

Auch in diesem Fall kann es günstig sein, die Stromzuführung lokal in Abhängigkeit von der jeweiligen Position des Fußpunktes des Plasma zu steuern.

Dies kann durch eine entsprechende Bewegung einer Stromzuführung zur Absorberelektrode 2 parallel zur Oberfläche des Targets 1 entlang seiner Längsachse erreicht werden.

Einfacher ist es jedoch, bei einer flächigen ebenen geschlossenen Absorberelektrode (z.B. Blech oder Gitter) Schlitze auszubilden, die von der in Richtung Target 1 weisenden Stirnseite ausgehen und kurz vor der in Richtung Substrat weisenden Stirnseite der Absorberelektrode 2 enden. Dadurch wird mit Hilfe dieser Schlitze ein direkter Stromfluß von der Stromzuführung in den Wirkbereich des Plasma verhindert, wenn sich der Plasmafußpunkt in einem Abstand von der in der Regel mittig an der Absorberelektrode 2 angeordneten Stromzuführung befindet.

## Patentansprüche

1. Vorrichtung zur Beschichtung von Substraten im Vakuum mit Verfahren, bei denen von einem Target ein Plasma erzeugt und ionisierte Teilchen des Plasmas auf dem Substrat (3) als Schicht abgeschieden werden, mit einer Absorberelektrode, und Mitteln um die Absorberelektrode in Bezug auf das Plasma auf ein elektrisch positives Potential zu legen, **dadurch gekennzeichnet, dass** die Absorberelektrode (2), als Umlenkanordnung für die positiv geladenen Ionen des Plasmas in Richtung zum Substrat (3), zwischen Target (1) und Substrat (3) so angeordnet, ausgerichtet und dimensioniert ist, dass der Teilchenstrom des Plasmas nicht auf direktem Weg zum Substrat gelangen kann.

2. Vorrichtung nach Anspruch 1, **gekennzeichnet durch** eine Anordnung der Absorberelektrode (2) derart, dass der Feldvektor des sich um die Absorberelektrode (2) ausbildbaren elektrischen Feldes zumindest annähernd orthogonal zur Bewegungsrichtung der ionisierten Teilchen des Plasmas ausgerichtet ist.

3. Vorrichtung nach Anspruch 1 oder 2, **gekennzeichnet durch** Mittel zum Anlegen einer mittleren Spannung im Bereich 180 bis 200 V an die Absorberelektrode (2).

4. Vorrichtung nach einem der Ansprüche 1 bis 3, **dadurch gekennzeichnet, dass** das als Kathode geschaltete Target (1') walzenförmig ausgebildet, und drehbar angeordnet ist, und dass Mittel vorgesehen sind, einen gepulster Laserstrahl (5) zu erzeugen und parallel zu einer Ebene der Drehachse des Targets (1') auf dessen Mantelfläche auszulenken.

5. Vorrichtung nach einem der Ansprüche 1 bis 4, **dadurch gekennzeichnet, dass** zwischen Substrat (3) und Target (1) eine das direkte Auftreffen ionisierter Teilchen verhindernde Blende (6) angeordnet ist.

6. Vorrichtung nach einem der Ansprüche 1 bis 5, **dadurch gekennzeichnet, dass** die Absorberelektrode (2) in Form eines eine Fläche aufspannenden Elementes ausgebildet ist.

7. Vorrichtung nach einem der Ansprüche 1 bis 6, **dadurch gekennzeichnet, dass** die Absorberelektrode (2) teilkreisförmig, in Richtung auf das Substrat (3) gekrümmt ausgebildet ist.

8. Vorrichtung nach einem der Ansprüche 1 bis 7, **dadurch gekennzeichnet, dass** der Spannungsanschluss an die Absorberelektrode (2) an der dem Target (1) zugewandten Seite der Absorberelektrode (2) angeordnet ist.

9. Vorrichtung nach einem der Ansprüche 1 bis 8, **dadurch gekennzeichnet, dass** die Absorberelektrode (2) aus mehreren Streifen (2') gebildet ist.

10. Vorrichtung nach einem der Ansprüche 1 bis 9, **dadurch gekennzeichnet, dass** die Absorberelektrode (2) so dimensioniert ist, dass zumindest annähernd im gesamten Raum zwischen Absorberelektrode (2) und Substrat (3) das elektrische Feld ausbildbar ist.

11. Vorrichtung nach einem der Ansprüche 1 bis 10, **dadurch gekennzeichnet, dass** die Absorberelektrode aus mehreren in einem Abstand zueinander, orthogonal zur Drehachse eines walzenförmigen Targets ausgerichteten, parallel angeordneten ebenen, flächigen und in Richtung auf das Substrat gekrümmten Elementen (2') gebildet ist.

12. Vorrichtung nach einem der Ansprüche 1 bis 11, **dadurch gekennzeichnet, dass** zwischen Fußpunkt des Plasmas und Absorberelektrode (2) ein gitterförmiges Element aus elektrisch leitendem Material, durch dass das Plasma geführt werden kann, angeordnet ist.

13. Verfahren zur Beschichtung von Substraten im Vakuum, bei dem von einem Target ein Plasma erzeugt und ionisierte Teilchen des Plasmas auf dem Substrat als Schicht abgeschieden und ionisierte Teilchen und Elektronen des erzeugten Plasmas durch ein um eine Absorberelektrode erzeugtes elektrisches Feld hindurch geführt und Elektronen durch die Absorberelektrode absorbiert werden,
**dadurch gekennzeichnet, dass** mittels der Absorberelektrode (2) positiv geladene Ionen des Plasmas zum Substrat (3) umgelenkt werden.

14. Verfahren nach Anspruch 13, **dadurch gekennzeichnet, dass** das Plasma mittels gepulster Energie aus dem Target erzeugt und die Spannung an der Absorberelektrode (2) ebenfalls gepulst betrieben wird.

15. Verfahren nach Anspruch 13 oder 14, **dadurch gekennzeichnet, dass** das Plasma mittels Bogenentladung zwischen dem als Kathode geschalteten Target (1) und einer Anode (4) erzeugt und die Spannung der Absorberlektrode (2) größer als die Spannung der Anode (4) gehalten wird.

16. Verfahren nach Anspruch 15, **dadurch gekennzeichnet, dass** das Plasma mittels gepulster Bogenentladung erzeugt wird.

17. Verfahren nach einem der Ansprüche 13 bis 16, **dadurch gekennzeichnet, dass** die Spannung der Absorberelektrode (2), der Spannung der Anode (4) nachfolgend geschaltet wird.

18. Verfahren nach einem der Ansprüche 13 bis 17, **dadurch gekennzeichnet, dass** die Bogenentladung zwischen dem als Kathode geschalteten Target (1) und der Anode (4) mittels eines gepulsten Laserstrahles (5) gezündet wird.

19. Verfahren nach Anspruch 18, **dadurch gekennzeichnet, dass** ein walzenförmiges Target (1) gleichförmig um seine Längsachse gedreht und der gepulste Laserstrahl (5) entlang einer Ebene, parallel zur Drehachse des Targets (1) über dessen Mantelfläche ausgelenkt wird.

20. Verfahren nach Anspruch 13, **dadurch gekennzeichnet, dass** das Plasma mittels Bogenentladung zwischen dem als Kathode geschalteten Target (1) und der Absorberelektrode (2) erzeugt wird.

21. Verfahren nach einem der Ansprüche 13 bis 20, **dadurch gekennzeichnet, dass** ein Gas oder Gasgemisch zugeführt wird.

## Claims

1. Device for coating substrates in vacuo using methods in which a plasma is generated from a target and ionized particles of the plasma are deposited on the substrate (3) in the form of a layer, having an absorber electrode and means for setting the absorber electrode at an electrically positive potential with respect to the plasma, **characterized in that** the absorber electrode (2), as a deflecting arrangement for the positively charged ions of the plasma in the direction of the substrate (3), is arranged between target (1) and substrate (3), oriented and dimensioned in such a way that the particle stream of the plasma cannot reach the substrate directly.

2. Device according to Claim 1, **characterized by** an arrangement of the absorber electrode (2) such that the field vector of the electric field which can form around the absorber electrode (2) is oriented at least approximately orthogonally to the direction of movement of the ionized particles of the plasma.

3. Device according to Claim 1 or 2, **characterized by** means for applying a mean voltage in the range from 180 to 200 V to the absorber electrode (2).

4. Device according to one of Claims 1 to 3, **characterized in that** the target (1'), which is connected as cathode, is designed in the form of a roller and is arranged rotatably, and **in that** means are provided for generating a pulsed laser beam (5) and for deflecting it, parallel to a plane of the axis of rotation of the target (1'), onto the circumferential surface thereof.

5. Device according to one of Claims 1 to 4, **characterized in that** a diaphragm (6), which prevents the direct impingment of ionized particles, is arranged between substrate (3) and target (1).

6. Device according to one of Claims 1 to 5, **characterized in that** the absorber electrode, (2) is designed in the form of an element which encompasses an area.

7. Device according to one of Claims 1 to 6, **characterized in that** the absorber electrode (2) is designed in the form of part of a circle, curved toward the substrate (3).

8. Device according to one of Claims 1 to 7, **characterized in that** the voltage connection to the absorber electrode (2) is arranged on that side of the absorber electrode (2) which faces the target (1).

9. Device according to one of Claims 1 to 8, **characterized in that** the absorber electrode (2) is formed from a plurality of strips (2').

10. Device according to one of Claims 1 to 9, **characterized in that** the absorber electrode (2) is dimensioned in such a way that the electric field can be formed at least approximately in the entire space between absorber electrode (2) and substrate (3).

11. Device according to one of Claims 1 to 10, **characterized in that** the absorber electrode is formed from a plurality of planar, large-area elements (2') which are oriented orthogonally to the axis of rotation of a roller-shaped target, arranged parallel to and at a distance from one another, and are curved toward the substrate.

12. Device according to one of Claims 1 to 11, **characterized in that** a grid-like element made from electrically conductive material, through which the plasma can be passed, is arranged between the root of the plasma and absorber electrode (2).

13. Method for coating substrates in vacuo, in which a plasma is generated from a target and ionized particles of the plasma are deposited on the substrate in the form of a layer, and ionized particles and electrons of the plasma generated are passed through an electric field which is generated around an absorber electrode, and electrons are absorbed by the absorber electrode, **characterized in that** positively charged ions of the plasma are diverted to the substrate (3) by means of the absorber electrode (2).

14. Method according to Claim 13, **characterized in that** the plasma is generated from the target by means of pulsed energy and the voltage at the absorber electrode (2) is likewise operated in pulsed form.

15. Method according to Claim 13 or 14, **characterized in that** the plasma is generated by means of arc discharge between the target (1), which is connected as cathode, and an anode (4), and the voltage of the absorber electrode (2) is kept higher than the voltage of the anode (4).

16. Method according to Claim 15, **characterized in that** the plasma is generated by means of pulsed arc discharge.

17. Method according to one of Claims 13 to 16, **characterized in that** the voltage of the absorber electrode (2) is connected downstream of the voltage of the anode (4).

18. Method according to one of Claims 13 to 17, **characterized in that** the arc discharge is ignited between the target (1) connected as cathode and the anode (4) by means of a pulsed laser beam (5).

19. Method according to Claim 18, **characterized in that** a target (1), which is in the form of a roller, is rotated uniformly about its longitudinal axis and the pulsed laser beam (5) is deflected along a plane running parallel to the axis of rotation of the target (1), over the circumferential surface thereof.

20. Method according to Claim 13, **characterized in that** the plasma is generated by means of arc discharge between the target (1), which is connected as cathode, and the absorber electrode (2).

21. Method according to one of Claims 13 to 20, **characterized in that** a gas or gas mixture is supplied.

## Revendications

1. Dispositif pour appliquer un revêtement sur des substrats sous vide au moyen de procédés, dans lesquels un plasma est généré par une cible et des particules ionisées du plasma sont déposées comme couche sur le substrat (3), avec une électrode d'absorption et des moyens pour appliquer à l'électrode d'absorption par rapport au plasma un potentiel électrique positif, **caractérisé en ce qu'**en tant qu'élément de déviation pour les ions chargés positivement du plasma, l'électrode d'absorption (2) est disposée, orientée et dimensionnée en direction du substrat (3) entre la cible (1) et le substrat (3) de telle façon que le flux de particules du plasma ne peut pas parvenir au substrat par la voie directe.

2. Dispositif selon la revendication 1, **caractérisé par** une disposition de l'électrode d'absorption (2) telle que le vecteur de champ du champ électrique qui peut se constituer autour de l'électrode d'absorption (2) est orienté au moins approximativement dans le sens orthogonal par rapport à la direction de déplacement des particules ionisées du plasma.

3. Dispositif selon la revendication 1 ou 2, **caractérisé par** des moyens pour appliquer à l'électrode d'absorption (2) une tension moyenne située dans la plage de 180 à 200 V.

4. Dispositif selon l'une quelconque des revendications 1 à 3, **caractérisé en ce que** la cible (1') qui est commutée comme cathode est configurée en forme de tambour et est disposée de manière tournante et **en ce que** des moyens pour générer un rayon laser pulsé (5) et pour le dévier parallèlement vers un plan de l'axe de rotation de la cible (1') sur la surface enveloppante de celle-ci sont prévus.

5. Dispositif selon l'une quelconque des revendications 1 à 4, **caractérisé en ce qu'**entre le substrat (3) et la cible (1) est disposé un blindage (6) qui évite une arrivée directe de particules ionisées.

6. Dispositif selon l'une quelconque des revendications 1 à 5, **caractérisé en ce que** l'électrode d'absorption (2) est configurée sous la forme d'un élément constituant une surface.

7. Dispositif selon l'une quelconque des revendications 1 à 6, **caractérisé en ce que** l'électrode d'absorption (2) est configurée en forme de portion de cercle coudé en direction du substrat (3).

8. Dispositif selon l'une quelconque des revendications 1 à 7, **caractérisé en ce que** le point de raccordement de la tension à l'électrode d'absorption (2) est disposé sur le côté de l'électrode d'absorption (2) qui est dirigé vers la cible (1).

9. Dispositif selon l'une quelconque des revendications 1 à 8, **caractérisé en ce que** l'électrode d'absorption (2) est formée de plusieurs lames (2').

10. Dispositif selon l'une quelconque des revendications 1 à 9, **caractérisé en ce que** l'électrode d'absorption (2) est dimensionnée de telle façon que le champ électrique puisse être constitué au moins approximativement dans l'ensemble du volume situé entre l'électrode d'absorption (2) et le substrat (3).

11. Dispositif selon l'une quelconque des revendications 1 à 10, **caractérisé en ce que** l'électrode d'absorption est formée de plusieurs éléments (2') avec un espacement entre eux qui sont plats, présentent une surface, sont coudés en direction du substrat et qui sont disposés en parallèle en étant orientés dans le sens orthogonal par rapport à l'axe de rotation d'une cible en forme de tambour.

12. Dispositif selon l'une quelconque des revendications 1 à 11, **caractérisé en ce qu'**entre le point de base du plasma et l'électrode d'absorption (2) est disposé un élément en forme de grille en matériau électroconducteur à travers lequel peut être conduit le plasma.

13. Procédé pour appliquer un revêtement sur des substrats sous vide, dans lequel un plasma est généré par une cible et des particules ionisées du plasma sont déposées comme couche sur le substrat, des particules ionisées et des électrons du plasma généré étant conduits à travers un champ électrique généré autour d'une électrode d'absorption et des électrons étant absorbés par l'électrode d'absorption,
**caractérisé en ce que** des ions du plasma chargés positivement sont déviés vers le substrat (3) au moyen de l'électrode d'absorption (2).

14. Procédé selon la revendication 13, **caractérisé en ce que** le plasma est généré à partir de la cible au moyen d'énergie pulsée et **en ce que** la tension à laquelle est soumise l'électrode d'absorption (2) est également exploitée en mode pulsé.

15. Procédé selon la revendication 13 ou 14, **caractérisé en ce que** le plasma est généré au moyen d'une décharge d'arc entre la cible (1) commutée en tant que cathode et une anode (4) et **en ce que** la tension de l'électrode d'absorption (2) est maintenue plus élevée que la tension de l'anode (4).

16. Procédé selon la revendication 15, **caractérisé en ce que** le plasma est généré au moyen d'une décharge d'arc pulsée.

17. Procédé selon l'une quelconque des revendications 13 à 16, **caractérisé en ce que** la mise en action de la tension de l'électrode d'absorption (2) a lieu à la suite de celle de la tension de l'anode (4).

18. Procédé selon l'une quelconque des revendications 13 à 17, **caractérisé en ce que** la décharge d'arc entre la cible (1) commutée en tant que cathode et l'anode (4) est amorcée au moyen d'un rayon laser pulsé (5).

19. Procédé selon la revendication 18, **caractérisé en ce qu'**une cible en forme de tambour (1) tourne de manière uniforme autour de son axe longitudinal et **en ce que** le rayon laser pulsé (5) est dévié le long d'un plan et parallèlement à l'axe de rotation de la cible (1) sur la surface enveloppante de celle-ci.

20. Procédé selon la revendication 13, **caractérisé en ce que** le plasma est généré au moyen d'une décharge d'arc entre la cible (1) commutée en tant que cathode et l'électrode d'absorption (2).

21. Procédé selon l'une quelconque des revendications 13 à 20, **caractérisé par** une alimentation en gaz ou en mélange gazeux.
